# EUROPEAN PATENT SPECIFICATION

(11) **EP 4 318 549 B1**
(45) Date of publication and mention of the grant of the patent: **04.06.2025**
(21) Application number: 22782645.0
(22) Date of filing: 30.06.2022
(51) Int. Cl.: H10B 12/00

(54) **SEMICONDUCTOR STRUCTURE AND FORMING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FORMATION

(30) Priority: 21.06.2022 CN 202210706322
(43) Date of publication of application: 07.02.2024
(73) Proprietor: Changxin Memory Technologies, Inc., Hefei City, Anhui 230601 (CN)
(72) Inventor: XIAO, Deyuan, Hefei, Anhui 230601 (CN); CAO, Kanyu, Hefei, Anhui 230601 (CN)
(74) Representative: Lavoix
(86) International application number: PCT/CN2022/102860
(87) International publication number: WO 2023/245716

(56) References cited:
- CN-A- 114 121 958
- CN-A- 114 551 450
- CN-A- 114 551 450
- US-A- 5 214 603
- US-A- 5 477 071
- US-A- 6 008 085
- US-A1- 2022 068 924
- US-A1- 2022 157 828
- US-A1- 2022 173 135
- US-B2- 11 094 698

## Description

### Cross-Reference to Related Applications

The present application claims the priority of Chinese Patent Application No. 202210706322.2, filed on June 21, 2022 and entitled "SEMICONDUCTOR STRUCTURE AND FORMING METHOD THEREOF".

### Technical Field

The present disclosure relates to the technical field of semiconductor manufacturing, and in particular to a semiconductor structure and a forming method thereof.

### Background

As a semiconductor device commonly used in an electronic device such as a computer, a dynamic random access memory (DRAM) includes a plurality of memory cells, and each of the memory cells usually includes a transistor and a capacitor. The transistor has a gate being electrically connected to a word line, a source being electrically connected to a bit line, and a drain being electrically connected to the capacitor. A word line voltage on the word line can control on and off of the transistor, such that data information stored in the capacitor can be read through the bit line or data information can be written into the capacitor through the bit line.

The semiconductor structure such as a DRAM with a transistor on capacitor (TOC) structure is not compatible with peripheral circuits due to the structural limitation, and leakage easily occurs between a capacitor and a substrate. In addition, the manufacturing process of DRAM and other semiconductor structure is complex and has high manufacturing cost.

Therefore, how to improve the performance of the semiconductor structure and reduce the difficulty of the semiconductor manufacturing process is an urgent technical problem to be solved. Related technology is known from CN 114 551 450 A, US 2022/068924 A1, US 11 094 698 B2, US 2022/173135 A1, and US 2022/157828 A1.

### Summary

A semiconductor structure and a forming method thereof provided by some embodiments of the present disclosure are used to improve the performance of the semiconductor structure and reduce the difficulty of the semiconductor manufacturing process. The invention is defined by the independent claim and its dependent claims.

In the semiconductor structure and the forming method thereof provided by some embodiments of the present disclosure, the transistor structure is arranged above the capacitive structure, and the bit line structure is arranged above the transistor structure, to form a semiconductor structure having a TOC structure. It is unnecessary to form a bit line structure below the transistor structure through a deep hole etching process, thereby reducing the manufacturing difficulty of bit lines, and reducing the manufacturing cost of the semiconductor structure. Moreover, because the bit line structure is located above the transistor structure, the bit line may be manufactured using various materials (such as a metal material), which helps reduce the resistance of the bit line and improve the performance of the semiconductor structure, such that the bit line is more compatible with a subsequent peripheral circuit process.

### Brief Description of the Drawings

FIG. 1 is a schematic diagram of a semiconductor structure according to a specific implementation of the present disclosure;
FIG. 2 is a flowchart of a method of forming a semiconductor structure according to a specific implementation of the present disclosure; and
FIG. 3 to FIG. 15 are schematic structural diagrams of main processes for forming a semiconductor structure according to a specific implementation of the present disclosure.

### Detailed Description

Specific implementations of a semiconductor structure and a forming method thereof provided in the present disclosure are described in detail below with reference to the accompanying drawings.

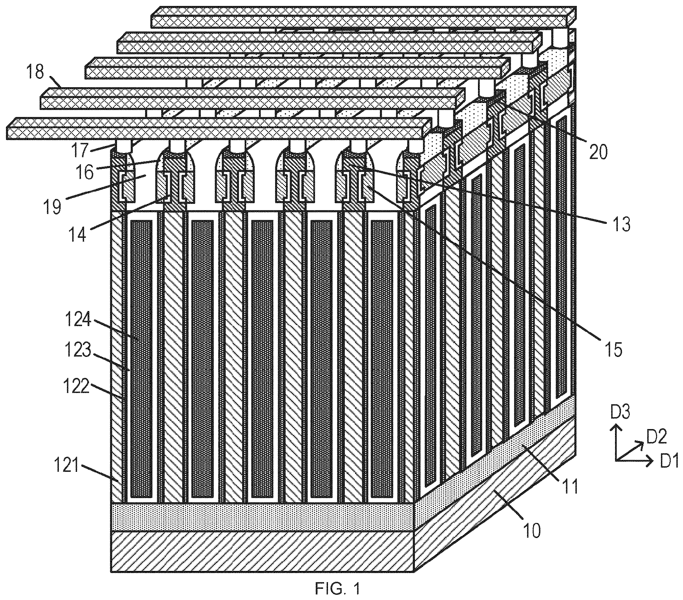

The specific implementation provides a semiconductor structure. FIG. 1 is a schematic structural diagram of a semiconductor structure according to a specific implementation of the present disclosure. In the specific implementation, the semiconductor structure may be, but is not limited to, a DRAM. As shown in FIG. 1, the semiconductor structure in the specific implementation includes:
a substrate 10;
a capacitive structure, located on a top surface of the substrate 10 and including a plurality of capacitors arranged in an array along a first direction D1 and a second direction D2, where the first direction D1 and the second direction D2 are each parallel to the top surface of the substrate 10, and the first direction D1 intersects with the second direction D2;
a transistor structure, located above the capacitive structure and including a plurality of active pillars 13 and a plurality of word lines 15, where the active pillar 13 is electrically connected to the capacitor, and the word line 15 extends along the second direction D2 and continuously cover the active pillars 13 arranged at intervals along the second direction D2; and
a bit line structure, located above the transistor structure and including a plurality of bit lines 18, where the bit line 18 extends along the first direction D1 and are electrically connected to the active pillars 13 arranged at intervals along the first direction D1.

Specifically, the substrate 10 may be, but is not limited to, a silicon substrate. This specific implementation is described by taking the substrate being the silicon substrate as an example. In other examples, the substrate 10 may be a semiconductor substrate such as a gallium nitride substrate, a gallium arsenide substrate, a gallium carbide substrate, a silicon carbide substrate, or a silicon-on-insulator (SOI) substrate. The substrate 10 is configured to support device structures thereon. A top surface of the substrate 10 refers to a surface of the substrate 10 on which the capacitive structure is formed.

The capacitive structure includes the plurality of capacitors arranged in a two-dimensional array along the first direction D1 and the second direction D2. Each of the capacitors extends along a third direction D3, where the third direction D3 is a direction perpendicular to the top surface of the substrate 10. The transistor structure is located above the capacitive structure, and the transistor structure includes the plurality of active pillars 13 arranged in a two-dimensional array along the first direction D1 and the second direction D2. The active pillar 13 includes a channel region, and a drain region and a source region arranged on two opposite sides of the channel region along the third direction D3. The capacitor is in contact with and electrically connected to the drain region. The transistor structure further includes a plurality of word lines 15, and a word line isolation layer 19 located between adjacent ones of the word lines 15. The word line 15 extends along the second direction D2, and continuously cover the active pillars 13 arranged at intervals along the second direction D2, to form the word line 15 of a channel-all-around structure. The bit line structure includes the plurality of bit lines 18. The bit line 18 is located above the transistor structure, such that the bit line 18 can be formed by using a metal material such as tungsten, thereby reducing the resistance of the bit lines and manufacturing difficulty of the bit lines. Moreover, by arranging the bit line 18 above the transistor structure, the bit line is compatible with peripheral circuit processes such as a processor core (CORE), a sense amplifier (SA), and input/output (I/O).

In some embodiments, the capacitor includes:
a bottom electrode, including a conductive pillar 121 and a conductive layer 122 covering a surface of the conductive pillar 121, where a top surface of the conductive pillar 121 is in contact with and electrically connected to the active pillar 13;
a dielectric layer 123, covering a surface of the conductive layer 122 ; and
a top electrode 124, covering a surface of the dielectric layer 123.

Specifically, the bottom electrode in the capacitor includes the conductive pillar 121 extending along the third direction D3 and the conductive layer 122 covering a sidewall of the conductive pillar 121. The dielectric layer 123 covers a sidewall of the conductive layer 122, a surface of the substrate isolation layer 11, and a bottom surface of the word line isolation layer 19. The top electrode 124 covers the surface of the dielectric layer 123.

In some embodiments, the dielectric layer 123 is made of any one or more of strontium titanate, aluminum oxide, zirconium oxide, and hafnium oxide, and the conductive layer 122 and the top electrode 124 each are made of any one or more of titanium, ruthenium, ruthenium oxide, and titanium nitride.

Specifically, the dielectric layer 123 may be made of a strontium titanate (STO) material with a high dielectric constant (HK); the conductive layer 122 and the top electrode 124 may be made of ruthenium or ruthenium oxide, etc., thereby reducing the height of the capacitor along the third direction D3, and reducing the etching depth during etching if the capacitor hole for forming the capacitor, to further reduce the process difficulty. In other examples, the dielectric layer 123 may be made of any one or more of aluminum oxide, zirconium oxide, and hafnium oxide; accordingly, the conductive layer 122 and the top electrode 124 are made of TiN, etc., to reduce the manufacturing cost of the semiconductor layer structure.

In some embodiments, a material of the conductive pillar 121 is a silicide material including first dopant ions, to enhance the conductivity of the conductive pillar 121. In an embodiment, the drain region includes second dopant ions. The second dopant ions and the first dopant ions are of a same type, to further reduce the contact resistance between the conductive pillar 121 and the drain region.

In some embodiments, the semiconductor structure further includes:
a substrate isolation layer 11, located between the substrate 10 and the capacitive structure.

Specifically, a material of the substrate isolation layer 11 may be, but is not limited to, an insulation material such as an oxide (such as silicon dioxide). The substrate isolation layer 11 is formed between the substrate 10 and the capacitive structure to isolate an electrical leakage channel from the bottom of the capacitor to the substrate 10, thereby reducing the electrical leakage between the capacitor and the substrate 10.

In some embodiments, the substrate isolation layer 11 includes:
a first substrate isolation sub-layer, continuously distributed below the plurality of conductive pillars 121; and
a second substrate isolation sub-layer, covering a surface of the first substrate isolation sub-layer.

Specifically, the substrate isolation layer 11 includes the first substrate isolation sub-layer continuously distributed below the plurality of conductive pillars 121 and the second substrate isolation sub-layer covering the surface of the first substrate isolation sub-layer, such that the forming process of the substrate isolation layer can be carried out while the capacitor hole is formed, to ensure that the substrate isolation layer is directly formed below the capacitor, thereby ensuring that the substrate isolation layer can be fully aligned with the bottom of the capacitor. This simplifies a manufacturing process of the semiconductor structure and reduces process difficulty of the semiconductor structure, and can further improve an effect of electrical isolation between the capacitor and the substrate.

In other examples, the substrate isolation layer 11 may also be a single-layer structure. For example, the substrate isolation layer 11 is a single oxide layer located between the substrate 10 and the capacitive structure.

In some embodiments, each of the active pillars 13 includes a channel region, and a drain region and a source region that are arranged on two opposite sides of the channel region along a direction perpendicular to the top surface of the substrate 10.

Moreover, along the first direction D1 and the second direction D2, a width of the source region is greater than a width of the channel region, and a width of the drain region is greater than the width of the channel region.

Specifically, along the third direction D3, the drain region is located below the channel region, the source region is located above the channel region, and the drain region is electrically connected to the bottom electrode of the capacitor. Along the first direction D1 and the second direction D2, the widths of the source region and the drain region are both greater than the width of the channel region, thereby providing a larger space for forming the word line 15, which not only helps simplify the manufacturing process of the semiconductor structure, but also helps further reduce the size of the semiconductor structure, to adapt to application requirements of different fields.

In some embodiments, the plurality of word lines 15 are arranged at intervals along the first direction D1; and the transistor structure further includes:
a word line isolation layer 19, located between adjacent ones of the word lines 15.

In some embodiments, the transistor structure further includes:
a protective layer 16, located between the word line isolation layer 19 and the active pillar 13 and covering a sidewall of the source region, and along the first direction D1, an edge of the protective layer 16 is flush with an edge of the word line 15.

Specifically, a material of the protective layer 16 may be, but is not limited to, an insulating material such as nitride (e.g., silicon nitride). The protective layer 16 not only can be used to electrically isolate two adjacent source regions, but also can be used as mask layer during forming of the word line 15, thereby reducing the number of masks and further reducing the manufacturing cost of the semiconductor structure.

In some embodiments, the transistor structure further includes source electrodes 20 located on top surfaces of the active pillars 13; and the bit line structure further includes:
a bit line plug 17, where a bottom surface of the bit line plug 17 is in contact with and connected to the source electrode 20, and a top surface of the bit line plug 17 is electrically connected to the bit line 18.

Specifically, the bit line plug 17 has one end electrically connected to the source electrode 20 and another end electrically connected to the bit line 18. The bit line 18 extends along the first direction D1, and the plurality of bit lines 18 are arranged at intervals along the second direction D2. Each of the bit lines 18 is electrically connected, through the bit line plug 17, to the plurality of source electrodes 20 arranged at intervals along the first direction D1. A material of the bit line plug 17 may be the same as a material of the bit line 18, for example, the material is tungsten or molybdenum.

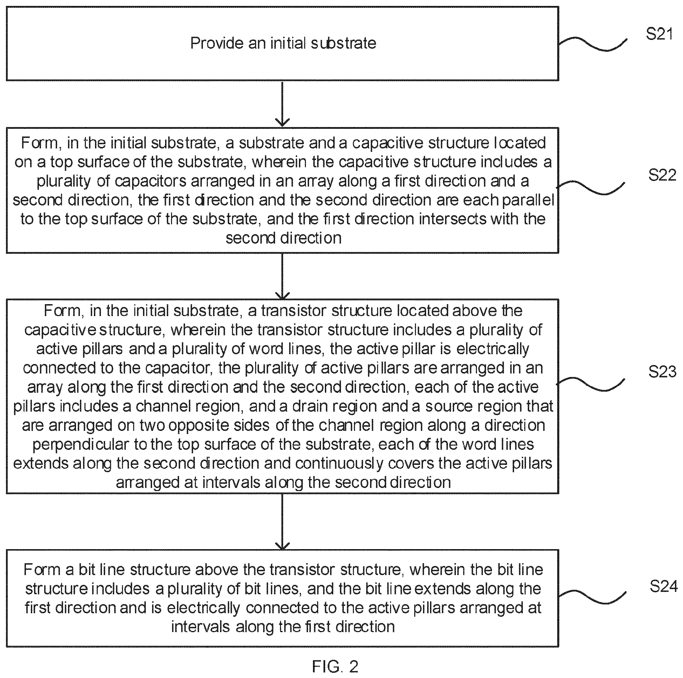

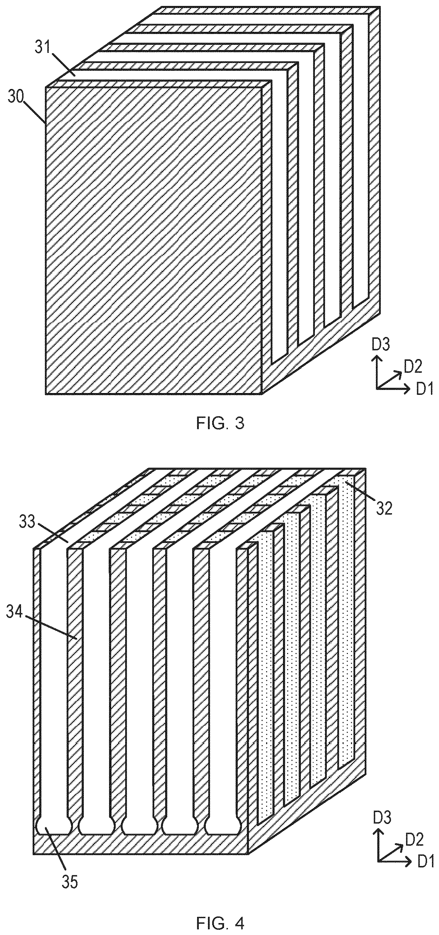

The specific implementation further provides a method of forming a semiconductor structure. FIG. 2 is a flowchart of a method of forming a semiconductor structure according to a specific implementation of the present disclosure. FIG. 3 to FIG. 15 are schematic structural diagrams of main processes for forming a semiconductor structure according to a specific implementation of the present disclosure. For the schematic diagram of a semiconductor structure formed in the specific implementation, refer to FIG. 1. As shown in FIG. 1 to FIG. 15, the method of forming a semiconductor structure includes the following steps:
Step S21: Provide an initial substrate 30, as shown in FIG. 3.

Specifically, the initial substrate 30 may be, but is not limited to, a silicon substrate. This specific implementation is described by using an example in which the initial substrate 30 is the silicon substrate. In other examples, the initial substrate 30 may be a semiconductor substrate such as a gallium nitride substrate, a gallium arsenide substrate, a gallium carbide substrate, a silicon carbide substrate or a silicon-on-insulator (SOI) substrate.

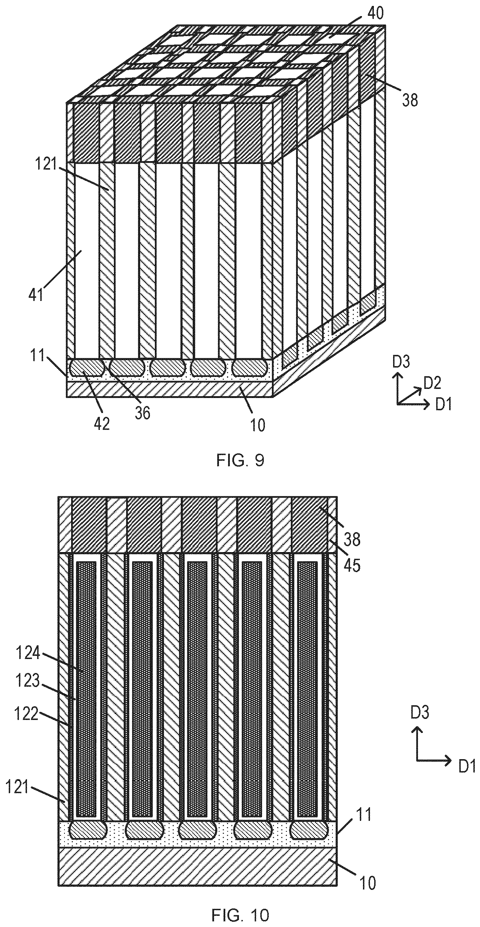

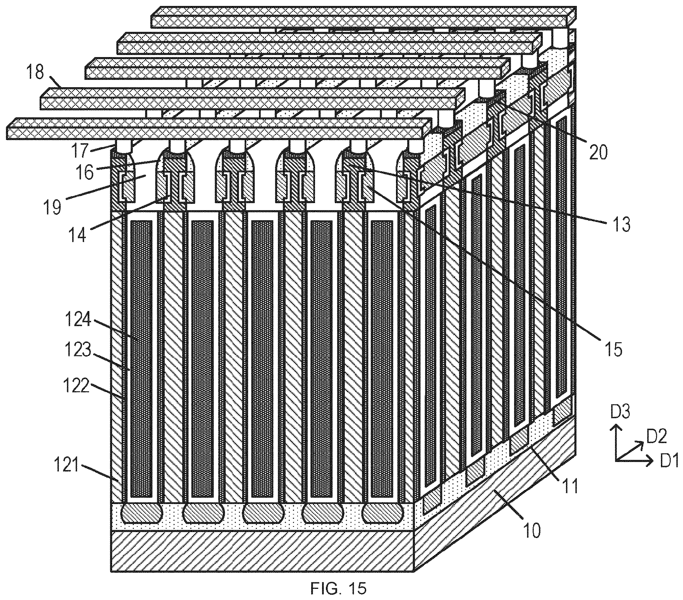

Step S22: Form, in the initial substrate 30, a substrate 10 and a capacitive structure located on a top surface of the substrate 10, where the capacitive structure includes a plurality of capacitors arranged in an array along a first direction D1 and a second direction D2, the first direction D1 and the second direction D2 are each parallel to the top surface of the substrate 10, and the first direction D1 intersects with the second direction D2, as shown in FIG. 10 and FIG. 15.

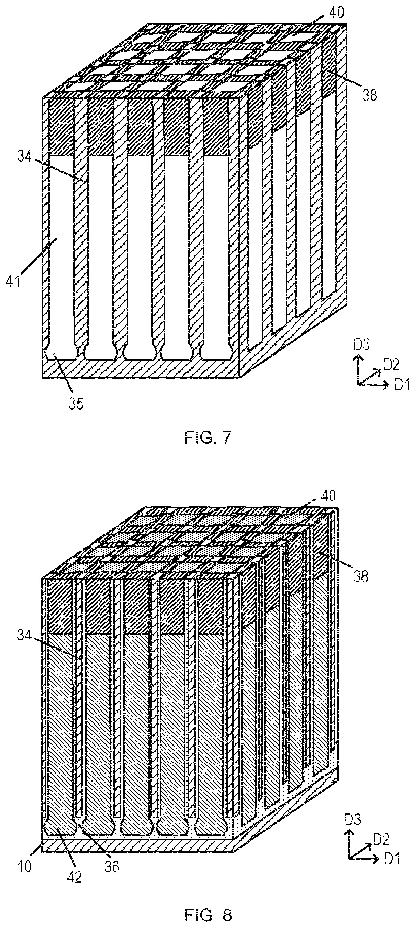

According to the invention, the step of forming, in the initial substrate 30, a substrate 10 and a capacitive structure located on a top surface of the substrate 10 specifically includes:
etching the initial substrate 30, and forming a plurality of semiconductor pillars 34 arranged in an array along the first direction D1 and the second direction D2, etching holes 41 each located between adjacent ones of the semiconductor pillars 34, and a plurality of recesses 35 in communication with the plurality of etching holes 41 in a one-to-one manner and located below the etching holes 41, as shown in FIG. 7;
forming a substrate isolation layer 11 connecting adjacent ones of the recesses 35 and filling up the recesses 35, and using the initial substrate 30 below the substrate isolation layer 11 as the substrate 10, as shown in FIG. 9; and
forming a capacitor in the etching hole 41, as shown in FIG. 10.

In some embodiments, the step of forming a plurality of semiconductor pillars 34 arranged in an array along the first direction D1 and the second direction D2, etching holes 41 each located between adjacent ones of the semiconductor pillars 34, and a plurality of recesses 35 in communication with the plurality of etching holes 41 in a one-to-one manner and located below the etching holes 41 specifically includes:
etching the initial substrate 30, and forming a plurality of first etching grooves 31, where each of the first etching grooves 31 extends along the first direction D1, and the plurality of first etching grooves 31 are arranged at intervals along the second direction D2, as shown in FIG. 3;
etching the initial substrate 30 to form a plurality of second etching grooves 33, where each of the second etching grooves 33 extends along the second direction D2, and the plurality of second etching grooves 33 are arranged at intervals along the first direction D1;
etching the initial substrate 30 at the bottom of each of the second etching grooves 33 to form, in the first direction D1, the recess 35 which is wider than the second etching groove 33, as shown in FIG. 4; and
connecting the first etching grooves 31 and the second etching grooves 33 to form the plurality of etching holes 41 and the semiconductor pillars 34 each located between adjacent ones of the etching holes 41.

In some embodiments, the step of forming the recess 35 which is wider than the second etching groove 33 specifically includes:
etching the initial substrate 30 at the bottom of the second etching groove 33 by using a Bosch etching process, to form the recess 35.

Specifically, the initial substrate 30 is etched along the third direction D3 by using a lithography process, to form a plurality of first etching grooves 31 that do not penetrate the initial substrate 30, where each of the first etching grooves 31 extends along the first direction D1, and the plurality of first etching grooves 31 are arranged at intervals along the second direction D2. The first etching groove 31 has a depth of 500 nm to 1200 nm along the third direction D3. Next, a material such as an oxide (such as silicon dioxide) to fill up the first etching groove 31, to form the first medium layer 32, as shown in FIG. 4. The first medium layer 32 is configured to support the initial substrate 30, to prevent the initial substrate 30 from tipping or collapsing during the process of forming the second etching groove 33. After the first medium layer 32 is formed, the initial substrate 30 may be etched again along the third direction D3 by using a lithography process, to form a plurality of second etching grooves 33 not penetrating the initial substrate 30, where each of the second etching grooves 33 extends along the second direction D2, and the plurality of second etching grooves 33 are arranged at intervals along the first direction D1. A depth of the second etching groove 33 along the third direction D3 may be less than that of the first etching groove 31, to facilitate subsequent forming of the recess 35 below the second etching groove 33. After the second etching groove 33 is formed, the initial substrate 30 is at the bottom of the second etching groove 33 is etched by using the Bosch etching process, to form the recess 35 that is in communication with the second etching groove 33 and has an inner diameter greater than that of the second etching groove 33, as shown in FIG. 4. The inner diameter of the recess 35 is greater than the inner diameter of the second etching groove 33. Therefore, in the first direction D1, a width of the semiconductor pillar 34 between adjacent ones of the second etching grooves 33 is greater than a width of the semiconductor pillar 34 between adjacent ones of the recesses 35.

In this specific implementation, the recess 25 is formed by using the Bosch etching process after the second etching groove 33 is formed, so as to simplify a forming process of the semiconductor structure. In other specific implementations, those skilled in the art can also select another etching process as needed to form the second etching groove 33 and the recess 35 connected to the second etching groove 33.

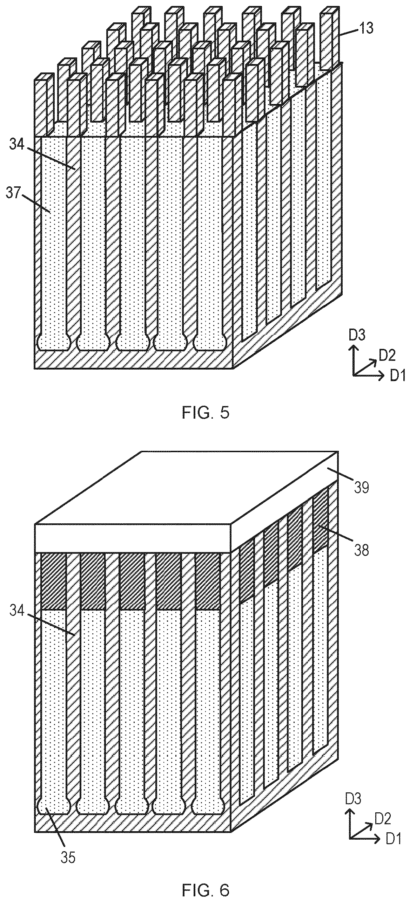

In some embodiments, the step of forming, in the initial substrate 30, a substrate 10 and a capacitive structure located on a top surface of the substrate 10 specifically further includes:
forming a sacrificial layer 37 filling up the etching hole 41 and the recess 35;
etching back a part of the sacrificial layer 37 from the top surface of the initial substrate 30, to expose an upper portion of the semiconductor pillar 34, as shown in FIG. 5; and
forming, on a top surface of the sacrificial layer 37, a support layer 38 covering the exposed semiconductor pillar 34, as shown in FIG. 6.

Specifically, after the recess 35 is formed, an oxide (such as silicon dioxide) is deposited in the second etching groove 33 and the recess 35 to form a second medium layer filling up the second etching groove 33 and the recess 35. The first medium layer 32 and the second medium layer jointly form the sacrificial layer 37. Then, a part of the sacrificial layer 37 is etched back to expose the upper portion of the semiconductor pillar 34, as shown in FIG. 5. The exposed semiconductor pillar 34 may have a height of 50 nm to 200 nm along the third direction D3. Next, a support material is deposited on the top surface of the sacrificial layer 37 to form the support layer 38 covering the exposed semiconductor pillar 34. After the support layer 38 is planarized, the first mask layer 39 is formed on the top surface of the support layer 38, as shown in FIG. 6. The support material may be, but is not limited to, a nitride material (such as silicon nitride). A material of the first mask layer 39 may be, but is not limited to, a hard mask material such as polysilicon. On one hand, the support layer 38 protects the upper portion of the semiconductor pillar 34, to prevent the subsequent process of forming the capacitor from damaging the upper portion of the semiconductor pillar 34. On the other hand, the support layer 38 is further configured to support the semiconductor pillar 34, to prevent the semiconductor pillar 34 from tipping after the sacrificial layer 37 is removed subsequently.

In some embodiments, after the forming, on a top surface of the sacrificial layer 37, a support layer 38 covering the exposed semiconductor pillar 34, the method further includes the following steps:
removing the sacrificial layer 37, as shown in FIG. 7;
oxidizing the semiconductor pillar 34 between adjacent ones of the recesses 35, to form a first substrate isolation sub-layer 36; and
filling the recess 35 with an insulation material, to form a second substrate isolation sub-layer 42, where the first substrate isolation sub-layer 36 and the second substrate isolation sub-layer 42 are jointly used as the substrate isolation layer 11, as shown in FIG. 9.

Specifically, the first mask layer 39 is patterned by using a lithography process, to form, in the first mask layer 39, a plurality of first openings that penetrate the first mask layer 39 and expose the support layer 38. The first mask layer 39 is patterned by using a mask in which the first etching grooves 31 and the second etching grooves 33 are formed, such that the positions of the formed plurality of first openings are aligned with the plurality of etching holes respectively. The support layer 38 is etched downward along the first opening, to form, in the support layer 38, the second opening 40 exposing the sacrificial layer 37. After the first mask layer 39 is removed, the sacrificial layer 37 is removed by etching along the second opening 40, to obtain the structure as shown in FIG. 7.

After the sacrificial layer 37 is removed, in-situ oxidation may be performed on the semiconductor pillar 34 below the support layer 38. For example, the semiconductor pillar 34 below the support layer 38 is oxidized by using an in-situ steam generation method. The inner diameter of the recess 35 is greater than the inner diameter of the second etching groove 33. Therefore, in the first direction D1, a width of the semiconductor pillar 34 between adjacent ones of the second etching grooves 33 is greater than a width of the semiconductor pillar 34 between adjacent ones of the recesses 35. Therefore, oxidation parameters (for example, oxidation time and an oxidant dosage) can be controlled to completely oxidize the second semiconductor pillar 34 between adjacent ones of the recesses 35 and oxidize the surface of the semiconductor pillar 34 between adjacent ones of the etching holes 41, so as to form the first substrate isolation sub-layer 36 covering the sidewall of the etching hole 41, located between the adjacent ones of the recesses 35, and covering the bottom surface of the recess 35. After that, the second substrate isolation sub-layer 42 is deposited along the second opening 40, to form the structure as shown in FIG. 8. Next, back etching is performed to remove the first substrate isolation sub-layer 36 and the second substrate isolation sub-layer 42 that are located in the etching hole 41, where the remaining first substrate isolation sub-layer 36 and second substrate isolation sub-layer 42 are jointly used as the substrate isolation layer 11, as shown in FIG. 9.

In some embodiments, the etching hole 41 located between the substrate isolation layer 11 and the support layer 38 is used as a capacitor hole, and a material of the initial substrate 30 is silicon; and the step of forming a capacitor in the etching hole 41 specifically includes:
implanting first dopant ions into the semiconductor pillar 34 between adjacent ones of the capacitor holes, to form an initial conductive pillar;
depositing a metal material on the initial conductive pillar, to form a conductive pillar 121 whose material includes a silicide, as shown in FIG. 9; and
sequentially forming a conductive layer 122 covering a sidewall of the conductive pillar 121, a dielectric layer 123 covering a sidewall of the conductive layer 122, and a top electrode 124 covering a surface of the dielectric layer 123, as shown in FIG. 10.

Specifically, after the first substrate isolation sub-layer 36 and the second substrate isolation sub-layer 42 in the etching hole 41 are removed through back etching, the first dopant ions (such as N-type ions) are implanted to the semiconductor pillar 34 between adjacent ones of the capacitor holes by using a plasma implantation or vapor diffusion method, to form an initial conductive pillar, to enhance the conductivity of the initial conductive pillar. Then, a metal material such as nickel is deposited on the surface of the initial conductive pillar through an atomic layer deposition process; next, the conductive pillar 121 made of metal silicide is formed through thermal processing, to further enhance the conductivity of the conductive pillar 121. Then, the conductive layer 122 covering the sidewall of the conductive pillar 121, the dielectric layer 123 covering the sidewall of the conductive layer 122, and the top electrode 124 covering the surface of the dielectric layer 123 are sequentially formed, to form the capacitor including the conductive pillar 121, the conductive layer 122, the dielectric layer 123, and the top electrode 124.

To reduce the etching steps and further simplify the manufacturing process of the semiconductor structure, in some embodiments, the step of forming a conductive layer 122 covering a sidewall of the conductive pillar 121 specifically includes:
directly forming, by using a selective atomic layer deposition process, the conductive layer 122 covering only the sidewall of the conductive pillar 121.

In some embodiments, the dielectric layer 123 is made of any one or more of strontium titanate, aluminum oxide, zirconium oxide, and hafnium oxide, and the conductive layer 122 and the top electrode each are made of any one or more of titanium, ruthenium, ruthenium oxide, and titanium nitride.

Specifically, the dielectric layer 123 may be made of a strontium titanate (STO) material with a high dielectric constant (HK); the conductive layer 122 and the top electrode 124 may be made of ruthenium or ruthenium oxide, etc., thereby reducing the height of the capacitor along the third direction D3, and reducing the etching depth during etching if the capacitor hole for forming the capacitor, to further reduce the process difficulty. In other examples, the dielectric layer 123 may be made of any one or more of aluminum oxide, zirconium oxide, and hafnium oxide; accordingly, the conductive layer 122 and the top electrode 124 are made of TiN, etc., to reduce the manufacturing cost of the semiconductor layer structure.

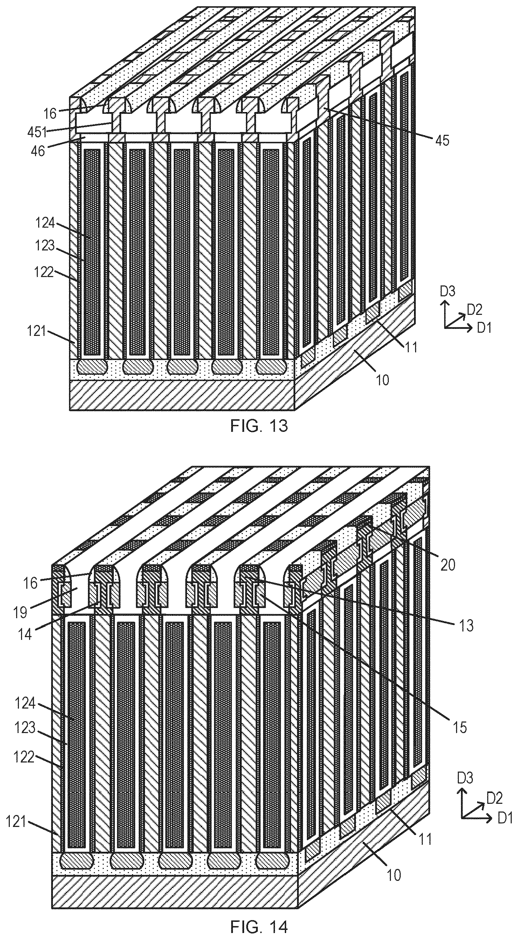

Step S23: Form, in the initial substrate 30, a transistor structure located above the capacitive structure, where the transistor structure includes a plurality of active pillars 13 and a plurality of word lines 15, the active pillars 13 are electrically connected to the capacitors, and the word lines 15 extend along the second direction D2 and continuously cover the active pillars 13 arranged at intervals along the second direction D2, as shown in FIG. 14.

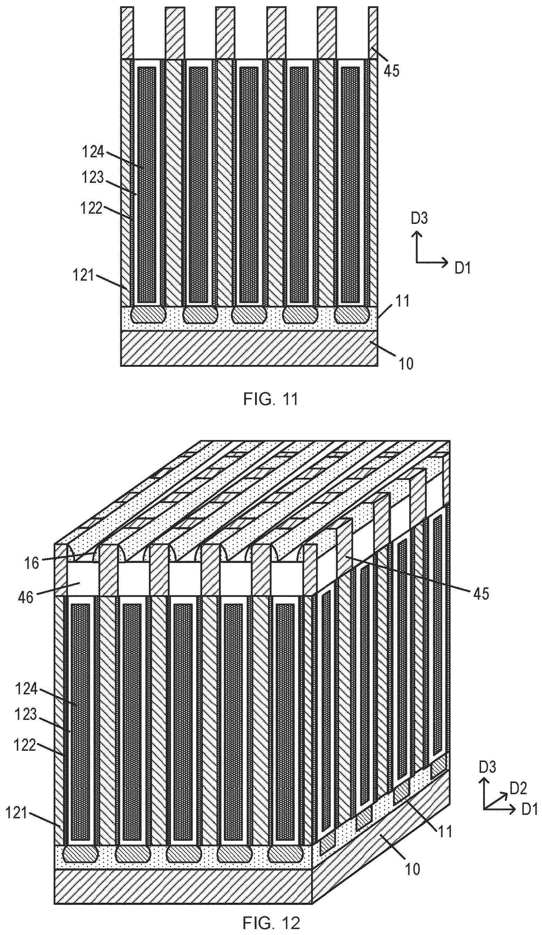

In some embodiments, the step of forming, in the initial substrate 30, a transistor structure located above the capacitive structure specifically includes:
removing the support layer 38 to expose upper portions of the etching holes 41 and the upper portions of the semiconductor pillars 34, using the exposed semiconductor pillars 34 as the active pillars 13, and defining, in each of the active pillars 13, a channel region, a drain region located below the channel region and in contact with the conductive pillar 121, and a source region located above the channel region, as shown in FIG. 11;
reducing widths of the channel region 451 along the first direction D1 and the second direction D2, as shown in FIG. 13; and
forming the word lines 15 extending along the second direction D2 and continuously covering the plurality of channel regions that are arranged at intervals along the second direction D2, as shown in FIG. 14.

In some embodiments, the step of reducing widths of the channel region along the first direction D1 and the second direction D2 specifically includes:
forming a filling layer 46 that fills up the etching hole 41 between the adjacent ones of the active pillars 13, as shown in FIG. 12;
etching back a part of the filling layer 46, to expose the source region;
forming a protective layer 16 covering a sidewall of the source region, as shown in FIG. 12;
etching back a part of the filling layer 46 again to expose the channel region 451, and using the remaining filling layer 46 on a sidewall of the drain region as an initial isolation layer;
performing modification processing on a sidewall of the exposed channel region 451 to form a modified layer; and
removing the modified layer, to reduce the widths of the channel region 451 along the first direction D1 and the second direction D2.

Specifically, after the protective layer 16 is formed, a part of the filling layer 46 is further etched back to form the channel region 451 in the active pillar 13. In the back etching process, to avoid penetration of the filling layer 46, a one-step etching process or a two-step etching process may be used and appropriate etching parameters (for example, a temperature or a pressure) are selected, such that a particular thickness of the first initial isolation layer can be retained. Specifically, the sidewall of the source region in the active pillar 13 is covered by the protective layer 16, and the sidewall of the drain region is covered by the initial isolation layer. Therefore, the modification processing on the channel region 451 does not cause damage to the source region and the drain region. In this specific implementation, the modification processing is performed on the sidewall of the channel region 451, such that there is a relatively high etch selectivity (for example, an etch selectivity greater than 3) between the sidewall of the channel region 451 and the interior of the channel region 451 surrounded by the sidewall of the channel region 451. In this way, the modified sidewall of the channel region 451 can be subsequently removed through selective etching, thereby reducing the width of the channel region 451 and enlarging the gap between adjacent ones of the channel regions 451, to reserve a larger space for subsequent forming of the word lines 15.

Because a thermal oxidation processing operation process is relatively simple, in some embodiments, the modification processing is thermal oxidation processing, and the modified layer is an oxide layer.

After the widths of the channel region 451 along the first direction D1 and the second direction D2 are reduced, the sidewall of the channel region is oxidized, to form the gate dielectric layer 14. Then, the word line 15 only extending along the second direction D2 is directly formed by using the selective atomic layer deposition process. Next, a second initial isolation layer is deposited between adjacent ones of the active pillars 13, to form the word line isolation layer 19 including the first initial isolation layer and the second initial isolation layer.

In other examples, after a word line material is deposited by using an atomic layer deposition process, the word line material is etched back, to form the word line 15 only extending along the second direction D2.

In some embodiments, after the forming the word lines 15 extending along the second direction D2 and continuously covering the plurality of channel regions that are arranged at intervals along the second direction D2, the method further includes:
implanting second dopant ions to the source region, the channel region, and the drain region, where the second dopant ions and the first dopant ions are of a same ion type.

In some embodiments, after the implanting second dopant ions to the source region, the channel region, and the drain region, the method further includes the following step:
depositing a metal material on a surface of the source region to form a source electrode 20 whose material includes a silicide, as shown in FIG. 14.

Step S24: Form a bit line structure above the transistor structure, where the bit line structure includes a plurality of bit lines 18, and the bit line 18 extends along the first direction D1 and are electrically connected to the active pillars 13 arranged at intervals along the first direction D1, as shown in FIG. 15.

In some embodiments, the step of forming a bit line structure above the transistor structure specifically includes:
forming a plurality of bit line plugs 17 located on top surfaces of the plurality of source electrodes 20 respectively; and
forming the plurality of bit lines 18 above the bit line plugs 17, where the plurality of bit lines 18 are arranged at intervals along the second direction D2, and each of the bit lines 18 extends along the first direction D1 and is in contact with and electrically connected to the plurality of bit line plugs 17 arranged at intervals along the first direction D1.

In the semiconductor structure and the forming method thereof provided by some embodiments of the specific implementation, the transistor structure is arranged above the capacitive structure, and the bit line structure is arranged above the transistor structure, to form a semiconductor structure having a TOC structure. It is unnecessary to form a bit line structure below the transistor structure through a deep hole etching process, thereby reducing the manufacturing difficulty of bit lines, and reducing the manufacturing cost of the semiconductor structure. Moreover, because the bit line structure is located above the transistor structure, the bit line may be manufactured using various materials (such as a metal material), which helps reduce the resistance of the bit line and improve the performance of the semiconductor structure, such that the bit line is more compatible with a subsequent peripheral circuit process.

The above described are merely preferred implementations of the present disclosure. It should be noted that several improvements and modifications may further be made by a person of ordinary skill in the art without departing from the principle of the present disclosure, and such improvements and modifications should also be deemed as falling within the protection scope of the present disclosure.

## Claims

1. A method of forming a semiconductor structure, **characterized by** comprising:
providing an initial substrate (30) (S21);
forming, in the initial substrate (30), a substrate (10) and a capacitive structure located on a top surface of the substrate (10), wherein the capacitive structure comprises a plurality of capacitors arranged in an array along a first direction (D1) and a second direction (D2), the first direction (D1) and the second direction (D2) are each parallel to the top surface of the substrate (10), and the first direction (D1) intersects with the second direction (D2) (S22);
forming, in the initial substrate (30), a transistor structure located above the capacitive structure, wherein the transistor structure comprises a plurality of active pillars (13) and a plurality of word lines (15), the active pillar (13) is electrically connected to the capacitor, and the word line (15) extends along the second direction (D2) and continuously cover the active pillars (13) arranged at intervals along the second direction (D2) (S23); and
forming a bit line structure above the transistor structure, wherein the bit line structure comprises a plurality of bit lines (18), and the bit line (18) extends along the first direction (D1) and are electrically connected to the active pillars (13) arranged at intervals along the first direction (D1) (S24);
wherein the forming, in the initial substrate (30), a substrate (10) and a capacitive structure located on a top surface of the substrate (10) specifically comprises:
etching the initial substrate (30), and forming a plurality of semiconductor pillars (34) arranged in an array along the first direction (D1) and the second direction (D2), etching holes (41) each located between adjacent ones of the semiconductor pillars (34), and a plurality of recesses (35) in communication with the plurality of etching holes (41) in a one-to-one manner and located below the etching holes (41);
forming a substrate isolation layer (11) connecting adjacent ones of the recesses (35) and filling up the recesses (35), and using the remaining initial substrate (30) below the substrate isolation layer (11) as the substrate (10); and
forming a capacitor in the etching hole (41).

2. The method of forming the semiconductor structure according to claim 1, wherein the forming a plurality of semiconductor pillars (34) arranged in an array along the first direction (D1) and the second direction (D2), etching holes (41) each located between adjacent ones of the semiconductor pillars (34), and a plurality of recesses (35) in communication with the plurality of etching holes (41) in a one-to-one manner and located below the etching holes (41) specifically comprises:
etching the initial substrate (30), and forming a plurality of first etching grooves (31), wherein each of the first etching grooves (31) extends along the first direction (D1), and the plurality of first etching grooves (31) are arranged at intervals along the second direction (D2);
etching the initial substrate (30), and forming a plurality of second etching grooves (33), wherein each of the second etching grooves (33) extends along the second direction (D2), and the plurality of second etching grooves (33) are arranged at intervals along the first direction (D1);
etching the initial substrate (30) at a bottom of each of the second etching grooves (33) to form, in the first direction (D1), a width of the recess (35) which is greater than a width of the second etching groove (33); and
connecting the first etching grooves (31) and the second etching grooves (33) to form the plurality of etching holes (41) and the semiconductor pillars (34) each located between adjacent ones of the etching holes (41);
wherein the forming a width of the recess (35) is greater than a width of the second etching groove (33) specifically comprises:
etching the initial substrate (30) at the bottom of the second etching groove (33) by using a Bosch etching process, to form the recess (35).

3. The method of forming the semiconductor structure according to claim 2, wherein the forming, in the initial substrate (30), a substrate (10) and a capacitive structure located on a top surface of the substrate (10) further specifically comprises:
forming a sacrificial layer (37) filling up the etching hole (41) and the recess (35);
etching back a part of the sacrificial layer (37) from the top surface of the initial substrate (30), to expose an upper portion of the semiconductor pillar (34); and
forming, on a top surface of the sacrificial layer (37), a support layer (38) covering the exposed semiconductor pillar (34);
wherein after the forming, on a top surface of the sacrificial layer (37), a support layer (38) covering the exposed semiconductor pillar (34), the method further comprises:
removing the sacrificial layer (37);
oxidizing the semiconductor pillar (34) between adjacent ones of the recesses (35), to form a first substrate isolation sub-layer (36);
filling the recess (35) with an insulation material, to form a second substrate isolation sub-layer (42), wherein the first substrate isolation sub-layer (36) and the second substrate isolation sub-layer (42) are jointly used as the substrate isolation layer (11).

4. The method of forming the semiconductor structure according to claim 3, wherein the etching hole (41) located between the substrate isolation layer (11) and the support layer (38) is used as a capacitor hole, and a material of the initial substrate (30) is silicon; and the forming a capacitor in the etching hole (41) specifically comprises:
implanting first dopant ions into the semiconductor pillar (34) between adjacent ones of the capacitor holes, to form an initial conductive pillar;
depositing a metal material on the initial conductive pillar, to form a conductive pillar (121) whose material comprises a silicide; and
sequentially forming a conductive layer (122) covering a sidewall of the conductive pillar (121), a dielectric layer (123) covering a sidewall of the conductive layer (122), and a top electrode (124) covering a surface of the dielectric layer (123);
wherein the forming a conductive layer (122) covering a sidewall of the conductive pillar (121) specifically comprises:
directly forming, by using a selective atomic layer deposition process, the conductive layer (122) covering only the sidewall of the conductive pillar (121).

5. The method of forming the semiconductor structure according to claim 4, wherein the dielectric layer (123) is made of any one or more of strontium titanate, aluminum oxide, zirconium oxide, and hafnium oxide, and the conductive layer (122) and the top electrode (124) each are made of any one or more of titanium, ruthenium, ruthenium oxide, and titanium nitride.

6. The method of forming the semiconductor structure according to claim 4, wherein the forming, in the initial substrate (30), a transistor structure located above the capacitive structure specifically comprises:
removing the support layer (38) to expose an upper portion of the etching hole (41) and the upper portion of the semiconductor pillar (34), using the exposed semiconductor pillar (34) as the active pillar (13), and defining, in the active pillar (13), a channel region (451), a drain region located below the channel region (451) and in contact with the conductive pillar (121), and a source region located above the channel region (451);
reducing a width of the channel region (451) along the first direction (D1) and the second direction (D2); and
forming the word line (15) extending along the second direction (D2) and continuously covering the plurality of channel regions (451) that are arranged at intervals along the second direction (D2);
wherein the reducing a width of the channel region (451) along the first direction (D1) and the second direction (D2) specifically comprises:
forming a filling layer (46) that fills up the etching hole (41) between the adjacent ones of the active pillars (13);
etching back a part of the filling layer (46), to expose the source region;
forming a protective layer (16) covering a sidewall of the source region;
etching back a part of the filling layer (46) again to expose the channel region (451), and using the remaining filling layer (46) on a sidewall of the drain region as an initial isolation layer;
performing modification processing on a sidewall of the exposed channel region (451) to form a modified layer; and
removing the modified layer, to reduce the width of the channel region (451) along the first direction (D1) and the second direction (D2); and
wherein the modification processing is thermal oxidation processing, and the modified layer is an oxide layer.

7. The method of forming a semiconductor structure according to claim 6, wherein after the forming the word line (15) extending along the second direction (D2) and continuously covering the plurality of channel regions (451) that are arranged at intervals along the second direction (D2), the method further comprises:
implanting second dopant ions to the source region, the channel region (451), and the drain region, wherein the second dopant ions and the first dopant ions are of a same ion type;
wherein after the implanting second dopant ions to the source region, the channel region (451), and the drain region, the method further comprises:
depositing the metal material on a surface of the source region to form a source electrode (20) whose material comprises a silicide.

8. The method of forming the semiconductor structure according to claim 7, wherein the forming a bit line structure above the transistor structure specifically comprises:
forming a plurality of bit line plugs (17) located on top surfaces of the plurality of source electrodes (20) respectively; and
forming the plurality of bit lines (18) above the bit line plugs (17), wherein the plurality of bit lines (18) are arranged at intervals along the second direction (D2), and each of the bit lines (18) extends along the first direction (D1) and is in contact with and electrically connected to the
plurality of bit line plugs (17) arranged at intervals along the first direction (D1).

## Patentansprüche

1. Verfahren zum Bilden einer Halbleiterstruktur, **dadurch gekennzeichnet, dass** es Folgendes umfasst:
Bereitstellen eines Ausgangssubstrats (30) (S21);
Bilden, in dem Ausgangssubstrat (30), eines Substrats (10) und einer kapazitiven Struktur, die sich auf einer oberen Fläche des Substrats (10) befindet, wobei die kapazitive Struktur eine Vielzahl von Kondensatoren umfasst, die in einer Anordnung entlang einer ersten Richtung (D1) und einer zweiten Richtung (D2) angeordnet sind, die erste Richtung (D1) und die zweite Richtung (D2) jeweils parallel zu der oberen Oberfläche des Substrats (10) sind, und sich die erste Richtung (D1) mit der zweiten Richtung (D2) (S22) schneidet;
Bilden, in dem Ausgangssubstrat (30), einer Transistorstruktur, die sich über der kapazitiven Struktur befindet, wobei die Transistorstruktur eine Vielzahl von aktiven Säulen (13) und eine Vielzahl von Wortleitungen (15) umfasst, die aktive Säule (13) elektrisch mit dem Kondensator verbunden ist, und sich die Wortleitung (15) entlang der zweiten Richtung (D2) erstreckt und die in Abständen entlang der zweiten Richtung (D2) angeordneten aktiven Säulen (13) kontinuierlich abdeckt (S23); und
Bilden einer Bitleitungsstruktur oberhalb der Transistorstruktur, wobei die Bitleitungsstruktur eine Vielzahl von Bitleitungen (18) umfasst, und sich die Bitleitung (18) entlang der ersten Richtung (D1) erstreckt und elektrisch mit den aktiven Säulen (13) verbunden ist, die in Abständen entlang der ersten Richtung (D1) angeordnet sind (S24);
wobei das Bilden, in dem Ausgangssubstrat (30), eines Substrats (10) und einer kapazitiven Struktur, die sich auf einer oberen Oberfläche des Substrats (10) befindet, spezifisch Folgendes umfasst:
Ätzen des Ausgangssubstrats (30) und Bilden einer Vielzahl von Halbleitersäulen (34), die in einem Feld entlang der ersten Richtung (D1) und der zweiten Richtung (D2) angeordnet sind, Ätzlöcher (41), die jeweils zwischen benachbarten der Halbleitersäulen (34) angeordnet sind, und eine Vielzahl von Vertiefungen (35), die mit der Vielzahl von Ätzlöchern (41) in einer Eins-zu-Eins-Verbindung sind und sich unter den Ätzlöchern (41) befinden;
Bilden einer Substratisolationsschicht (11), die benachbarte der Vertiefungen (35) verbindet und die Vertiefungen (35) auffüllt, und Verwenden des verbleibenden Ausgangssubstrats (30) unter der Substratisolationsschicht (11) als das Substrat (10); und
Bilden eines Kondensators in dem Ätzloch (41).

2. Verfahren zum Bilden einer Halbleiterstruktur nach Anspruch 1, wobei das Bilden einer Vielzahl von Halbleitersäulen (34), die in einem Feld entlang der ersten Richtung (D1) und der zweiten Richtung (D2) angeordnet sind, Ätzlöcher (41), die jeweils zwischen benachbarten der Halbleitersäulen (34) angeordnet sind, und eine Vielzahl von Vertiefungen (35), die mit der Vielzahl von Ätzlöchern (41) in einer Eins-zu-Eins-Verbindung sind und sich unter den Ätzlöchern (41) befinden, spezifisch Folgendes umfasst:
Ätzen des Ausgangssubstrats (30) und Bilden einer Vielzahl von ersten Ätzrillen (31), wobei sich jede der ersten Ätzrillen (31) entlang der ersten Richtung (D1) erstreckt und die Vielzahl der ersten Ätzrillen (31) in Abständen entlang der zweiten Richtung (D2) angeordnet sind;
Ätzen des Ausgangssubstrats (30) und Bilden einer Vielzahl von zweiten Ätzrillen (33), wobei sich jede der zweiten Ätzrillen (33) entlang der zweiten Richtung (D2) erstreckt und die Vielzahl der zweiten Ätzrillen (33) in Abständen entlang der ersten Richtung (D1) angeordnet sind;
Ätzen des Ausgangssubstrats (30) an einem Boden jeder der zweiten Ätzrillen (33), um in der ersten Richtung (D1) eine Breite der Vertiefung (35) zu bilden, die größer ist als eine Breite der zweiten Ätzrille (33); und
Verbinden der ersten Ätzrillen (31) und der zweiten Ätzrillen (33), um die Vielzahl von Ätzlöchern (41) und die Halbleitersäulen (34) zu bilden, die sich jeweils zwischen benachbarten Ätzlöchern (41) befinden;
wobei das Bilden einer Breite der Vertiefung (35) größer ist als eine Breite der zweiten Ätzrille (33), spezifisch umfassend:
Ätzen des Ausgangssubstrats (30) an dem Boden der zweiten Ätzrille (33) unter Verwendung eines Bosch-Ätzverfahrens, um die Vertiefung (35) zu bilden.

3. Verfahren zum Bilden der Halbleiterstruktur nach Anspruch 2, wobei das Bilden, in dem Ausgangssubstrat (30), eines Substrats (10) und einer kapazitiven Struktur, die sich auf einer oberen Oberfläche des Substrats (10) befindet, ferner spezifisch Folgendes umfasst:
Bilden einer Opferschicht (37), die das Ätzloch (41) und die Vertiefung (35) auffüllt;
Zurückätzen eines Teils der Opferschicht (37) von der oberen Oberfläche des Ausgangssubstrats (30), um einen oberen Abschnitt der Halbleitersäule (34) freizulegen; und
Bilden, auf einer Oberseite der Opferschicht (37), einer Trägerschicht (38) die die freiliegende Halbleitersäule (34) bedeckt;
wobei das Verfahren nach Bilden einer die freiliegende Halbleitersäule (34) bedeckende Trägerschicht (38) auf einer Oberseite der Opferschicht (37) ferner Folgendes umfasst:
Entfernen der Opferschicht (37);
Oxidieren der Halbleitersäule (34) zwischen benachbarten Vertiefungen (35), um eine erste Substratisolationsteilschicht (36) zu bilden;
Auffüllen der Vertiefung (35) mit einem Isoliermaterial, um eine zweite Substratisolationsteilschicht (42) zu bilden, wobei die erste Substratisolationsteilschicht (36) und die zweite Substratisolationsteilschicht (42) gemeinsam als die Substratisolationsschicht (11) verwendet werden.

4. Verfahren zum Bilden der Halbleiterstruktur nach Anspruch 3, wobei das Ätzloch (41), das sich zwischen der Substratisolationsschicht (11) und der Trägerschicht (38) befindet, als ein Kondensatorloch verwendet wird und ein Material des ursprünglichen Substrats (30) Silizium ist; und wobei das Bilden eines Kondensators in dem Ätzloch (41) spezifisch Folgendes umfasst:
Implantieren erster Dotierstoffionen in die Halbleitersäule (34) zwischen benachbarten Kondensatorlöchern, um eine erste leitende Säule zu bilden;
Aufbringen eines Metallmaterials auf die anfängliche leitende Säule, um eine leitende Säule (121) zu bilden, deren Material ein Silizid umfasst; und
sequentielles Bilden einer leitenden Schicht (122), die eine Seitenwand der leitenden Säule (121) bedeckt, einer dielektrischen Schicht (123), die eine Seitenwand der leitenden Schicht (122) bedeckt, und einer oberen Elektrode (124), die eine Oberfläche der dielektrischen Schicht (123) bedeckt;
wobei das Bilden einer leitenden Schicht (122), die eine Seitenwand der leitenden Säule (121) bedeckt, spezifisch Folgendes umfasst:
direktes Bilden der leitenden Schicht (122), die nur die Seitenwand der leitenden Säule (121) bedeckt, durch Verwenden eines selektiven Atomschichtabscheidungsverfahrens.

5. Verfahren zum Bilden der Halbleiterstruktur nach Anspruch 4, wobei die dielektrische Schicht (123) aus einem oder mehreren von Strontiumtitanat, Aluminiumoxid, Zirkoniumoxid und Hafniumoxid gefertigt ist, und die leitende Schicht (122) und die obere Elektrode (124) jeweils aus einem oder mehreren der Elemente Titan, Ruthenium, Rutheniumoxid und Titannitrid gefertigt sind.

6. Verfahren zum Bilden der Halbleiterstruktur nach Anspruch 4, wobei das Bilden einer Transistorstruktur in dem Ausgangssubstrat (30), die sich oberhalb der kapazitiven Struktur befindet, spezifisch Folgendes umfasst:
Entfernen der Trägerschicht (38), um einen oberen Abschnitt des Ätzlochs (41) und den oberen Abschnitt der Halbleitersäule (34) freizulegen, Verwenden der freigelegten Halbleitersäule (34) als die aktive Säule (13), und Definieren eines Kanalbereichs (451), eines Drain-Bereichs, der sich unterhalb des Kanalbereichs (451) befindet und in Kontakt mit der leitenden Säule (121) ist, und eines Source-Bereichs, der sich oberhalb des Kanalbereichs (451) befindet, in der aktiven Säule (13);
Verringern einer Breite des Kanalbereichs (451) entlang der ersten Richtung (D1) und der zweiten Richtung (D2); und
Bilden der Wortleitung (15), die sich entlang der zweiten Richtung (D2) erstreckt und kontinuierlich die Vielzahl von Kanalbereichen (451) abdeckt, die in Abständen entlang der zweiten Richtung (D2) angeordnet sind;
wobei das Verringern einer Breite des Kanalbereichs (451) entlang der ersten Richtung (D1) und der zweiten Richtung (D2) spezifisch Folgendes umfasst:
Bilden einer Füllschicht (46), die das Ätzloch (41) zwischen den benachbarten aktiven Säulen (13) auffüllt;
Zurückätzen eines Teils der Füllschicht (46), um den Source-Bereich freizulegen;
Bilden einer Schutzschicht (16), die eine Seitenwand des Source-Bereichs bedeckt;
Zurückätzen eines Teils der Füllschicht (46), um den Kanalbereich (451) freizulegen, und Verwenden der verbleibenden Füllschicht (46) an einer Seitenwand des Drain-Bereichs als anfängliche Isolierschicht;
Durchführen von Modifikationsverarbeitung an einer Seitenwand des freigelegten Kanalbereichs (451), um eine modifizierte Schicht zu bilden; und
Entfernen der modifizierten Schicht, um die Breite des Kanalbereichs (451) entlang der ersten Richtung (D1) und der zweiten Richtung (D2) zu verringern; und
wobei das Modifikationsverfahren ein thermisches Oxidationsverfahren ist und die modifizierte Schicht eine Oxidschicht ist.

7. Verfahren zum Bilden einer Halbleiterstruktur nach Anspruch 6, wobei das Verfahren nach Bilden der Wortleitung (15), die sich entlang der zweiten Richtung (D2) erstreckt und die Vielzahl von Kanalbereichen (451), die in Abständen entlang der zweiten Richtung (D2) angeordnet sind, kontinuierlich bedeckt, ferner Folgendes umfasst:
Implantieren von zweiten Dotierstoff-Ionen in den Source-Bereich, den Kanal-Bereich (451) und den Drain-Bereich, wobei die zweiten Dotierstoff-Ionen und die ersten Dotierstoff-Ionen vom gleichen Ionen-Typ sind;
wobei das Verfahren nach Implantieren von zweiten Dotierstoff-Ionen in den Source-Bereich, den Kanalbereich (451) und den Drain-Bereich ferner Folgendes umfasst:
Aufbringen des Metallmaterials auf einer Oberfläche des Source-Bereichs, um eine Source-Elektrode (20) zu bilden, deren Material ein Silizid umfasst.

8. Verfahren zum Bilden der Halbleiterstruktur nach Anspruch 7, wobei das Bilden einer Bitleitungsstruktur über der Transistorstruktur spezifisch Folgendes umfasst:
Bilden einer Vielzahl von Bitleitungssteckern (17), die sich jeweils auf den oberen Oberflächen der Vielzahl von Source-Elektroden (20) befinden; und
Bilden der Vielzahl von Bitleitungen (18) über den Bitleitungssteckern (17), wobei die Vielzahl von Bitleitungen (18) in Abständen entlang der zweiten Richtung (D2) angeordnet sind und jede der Bitleitungen (18) sich entlang der ersten Richtung (D1) erstreckt und mit der Vielzahl von Bitleitungssteckern (17), die in Abständen entlang der ersten Richtung (D1) angeordnet sind, in Kontakt und elektrisch verbunden ist.

## Revendications

1. Procédé de formation d'une structure semi-conductrice, **caractérisée en ce qu'**il comprend :
la fourniture d'un substrat initial (30) (S21) ;
la formation, dans le substrat initial (30), d'un substrat (10) et d'une structure capacitive située sur une surface supérieure du substrat (10), dans lequel la structure capacitive comprend une pluralité de condensateurs disposés en réseau le long d'une première direction (D1) et d'une seconde direction (D2), la première direction (D1) et la seconde direction (D2) étant chacune parallèle à la surface supérieure du substrat (10), et la première direction (D1) croisant la seconde direction (D2) (S22) ;
la formation, dans le substrat initial (30), d'une structure de transistor située au-dessus de la structure capacitive, dans lequel la structure de transistor comprend une pluralité de piliers actifs (13) et une pluralité de lignes de mots (15), le pilier actif (13) est connecté électriquement au condensateur, et la ligne de mots (15) s'étend le long de la seconde direction (D2) et recouvre continuellement les piliers actifs (13) disposés à intervalles le long de la seconde direction (D2) (S23) ; et
la formation d'une structure de lignes de bits au-dessus de la structure du transistor, dans lequel la structure de lignes de bits comprend une pluralité de lignes de bits (18), et la ligne de bits (18) s'étend le long de la première direction (D1) et est connectée électriquement aux piliers actifs (13) disposés à intervalles le long de la première direction (D1) (S24) ;
dans lequel la formation, dans le substrat initial (30), d'un substrat (10) et d'une structure capacitive située sur une surface supérieure du substrat (10) comprend spécifiquement :
la gravure du substrat initial (30), et la formation d'une pluralité de piliers semi-conducteurs (34) disposés en réseau le long de la première direction (D1) et de la seconde direction (D2), de trous de gravure (41) situés chacun entre des piliers semi-conducteurs (34) adjacents, et d'une pluralité d'évidements (35) en communication avec la pluralité de trous de gravure (41) en face à face et situés sous les trous de gravure (41) ;
la formation d'une couche d'isolation du substrat (11) reliant les évidements adjacents (35) et remplissant les évidements (35), et l'utilisation du substrat initial restant (30) sous la couche d'isolation du substrat (11) comme substrat (10) ; et
la formation d'un condensateur dans le trou de gravure (41).

2. Procédé de formation de la structure semi-conductrice selon la revendication 1, dans lequel la formation d'une pluralité de piliers semi-conducteurs (34) disposés en réseau le long de la première direction (D1) et de la seconde direction (D2), de trous de gravure (41) situés chacun entre des piliers semi-conducteurs (34) adjacents, et d'une pluralité d'évidements (35) en communication avec la pluralité de trous de gravure (41) en face à face et situés sous les trous de gravure (41), comprend en particulier :
la gravure du substrat initial (30), et la formation d'une pluralité de premières rainures de gravure (31), dans lesquelles chacune des premières rainures de gravure (31) s'étend le long de la première direction (D1), et la pluralité de premières rainures de gravure (31) sont disposées à intervalles le long de la seconde direction (D2) ;
la gravure du substrat initial (30), et la formation d'une pluralité de secondes rainures de gravure (33), dans lesquelles chacune des secondes rainures de gravure (33) s'étend le long de la seconde direction (D2), et la pluralité de secondes rainures de gravure (33) sont disposées à intervalles le long de la première direction (D1) ;
la gravure du substrat initial (30) au fond de chacune des secondes rainures de gravure (33) pour former, dans la première direction (D1), une largeur de l'évidement (35) supérieure à la largeur de la seconde rainure de gravure (33) ; et
la connexion des premières rainures de gravure (31) et des secondes rainures de gravure (33) pour former la pluralité de trous de gravure (41) et les piliers semi-conducteurs (34) situés chacun entre des trous de gravure adjacents (41) ;
dans lequel la formation d'une largeur de l'évidement (35) supérieure à une largeur de la seconde rainure de gravure (33) comprend spécifiquement :
la gravure du substrat initial (30) au fond de la seconde rainure de gravure (33) à l'aide d'un procédé de gravure Bosch, afin de former l'évidement (35).

3. Procédé de formation de la structure semi-conductrice selon la revendication 2, dans lequel la formation, dans le substrat initial (30), d'un substrat (10) et d'une structure capacitive située sur une surface supérieure du substrat (10) comprend en outre spécifiquement :
la formation d'une couche sacrificielle (37) remplissant le trou de gravure (41) et l'évidement (35) ;
la gravure d'une partie de la couche sacrificielle (37) de la surface supérieure du substrat initial (30), afin d'exposer une partie supérieure du pilier semi-conducteur (34) ; et
la formation, sur une surface supérieure de la couche sacrificielle (37), d'une couche de support (38) couvrant le pilier semi-conducteur exposé (34) ;
dans lequel, après la formation, sur une surface supérieure de la couche sacrificielle (37), d'une couche de support (38) recouvrant le pilier semi-conducteur exposé (34), le procédé comprend en outre :
la dépose de la couche sacrificielle (37) ;
l'oxydation du pilier semi-conducteur (34) entre les évidements adjacents (35), pour former une première sous-couche d'isolation du substrat (36) ;
le remplissage de l'évidement (35) avec un matériau isolant pour former une seconde sous-couche d'isolation du substrat (42), la première sous-couche d'isolation du substrat (36) et la seconde sous-couche d'isolation du substrat (42) étant utilisées conjointement comme couche d'isolation du substrat (11).

4. Procédé de formation de la structure semi-conductrice selon la revendication 3, dans lequel le trou de gravure (41) situé entre la couche d'isolation du substrat (11) et la couche de support (38) est utilisé comme trou de condensateur, et un matériau du substrat initial (30) est le silicium ; et la formation d'un condensateur dans le trou de gravure (41) comprend spécifiquement :
l'implantation de premiers ions dopants dans le pilier semi-conducteur (34) entre les trous adjacents du condensateur, pour former un pilier conducteur initial ;
le dépôt d'un matériau métallique sur le pilier conducteur initial, pour former un pilier conducteur (121) dont le matériau comprend un siliciure ; et
la formation séquentielle d'une couche conductrice (122) couvrant une paroi latérale du pilier conducteur (121), d'une couche diélectrique (123) couvrant une paroi latérale de la couche conductrice (122), et d'une électrode supérieure (124) couvrant une surface de la couche diélectrique (123) ;
dans lequel la formation d'une couche conductrice (122) recouvrant une paroi latérale du pilier conducteur (121) comprend spécifiquement :
la formation directe, en utilisant un procédé de dépôt sélectif de couches atomiques, de la couche conductrice (122) couvrant uniquement la paroi latérale du pilier conducteur (121).

5. Procédé de formation de la structure semi-conductrice selon la revendication 4, dans lequel la couche diélectrique (123) est constituée d'un ou de plusieurs éléments parmi le titanate de strontium, l'oxyde d'aluminium, l'oxyde de zirconium et l'oxydes d'hafnium, et la couche conductrice (122) et l'électrode supérieure (124) sont chacune constituées d'un ou de plusieurs éléments parmi le titane, le ruthénium, l'oxyde de ruthénium et le nitrure de titane.

6. Procédé de formation de la structure semi-conductrice selon la revendication 4, dans lequel la formation, dans le substrat initial (30), d'une structure de transistor située au-dessus de la structure capacitive comprend spécifiquement :
la dépose de la couche de support (38) pour exposer une partie supérieure du trou de gravure (41) et la partie supérieure du pilier semi-conducteur (34), l'utilisation du pilier semi-conducteur exposé (34) comme pilier actif (13), et la définition, dans le pilier actif (13), d'une région de canal (451), d'une région de drain située au-dessous de la région de canal (451) et en contact avec le pilier conducteur (121), et d'une région de source située au-dessus de la région de canal (451) ;
la réduction de la largeur de la région du canal (451) le long de la première direction (D1) et de la seconde direction (D2) ; et
la formation de la ligne de mots (15) s'étendant le long de la seconde direction (D2) et couvrant continuellement la pluralité de régions de canaux (451) qui sont disposées à intervalles le long de la seconde direction (D2) ;
dans lequel la réduction de la largeur de la zone de canal (451) le long de la première direction (D1) et de la seconde direction (D2) comprend spécifiquement :
la formation d'une couche de remplissage (46) qui remplit le trou de gravure (41) entre les piliers actifs (13) adjacents ;
la gravure d'une partie de la couche de remplissage (46), afin d'exposer la région de source ;
la formation d'une couche protectrice (16) recouvrant une paroi latérale de la région de source ;
la gravure à nouveau d'une partie de la couche de remplissage (46) pour exposer la région du canal (451), et en utilisant la couche de remplissage restante (46) sur une paroi latérale de la région de drain comme couche d'isolation initiale ;
la réalisation d'un traitement de modification sur une paroi latérale de la région de canal exposée (451) pour former une couche modifiée ; et
la dépose de la couche modifiée, pour réduire la largeur de la région du canal (451) le long de la première direction (D1) et de la seconde direction (D2) ; et
dans lequel le traitement de modification est un traitement d'oxydation thermique, et la couche modifiée est une couche d'oxyde.

7. Procédé de formation d'une structure semi-conductrice selon la revendication 6, dans lequel, après la formation de la ligne de mots (15) s'étendant le long de la seconde direction (D2) et couvrant continuellement la pluralité de régions de canaux (451) qui sont disposées à intervalles le long de la seconde direction (D2), le procédé comprend en outre :
l'implantation de seconds ions dopants dans la région de source, la région de canal (451) et la région de drain, les seconds ions dopants et les premiers ions dopants étant du même type ;
dans lequel, après l'implantation de seconds ions dopants dans la région de source, la région de canal (451) et la région de drain, le procédé comprend en outre :
le dépôt du matériau métallique sur une surface de la région de source pour former une électrode source (20) dont le matériau comprend un siliciure.

8. Procédé de formation de la structure semi-conductrice selon la revendication 7, dans lequel la formation d'une structure de ligne de bits au-dessus de la structure de transistor comprend spécifiquement :
la formation d'une pluralité de fiches de ligne de bits (17) situés sur les surfaces supérieures de la pluralité d'électrodes de source (20) respectivement ; et
la formation de la pluralité de lignes de bits (18) au-dessus des fiches de lignes de bits (17), la pluralité de lignes de bits (18) étant disposées à intervalles le long de la seconde direction (D2), et chacune des lignes de bits (18) s'étendant le long de la première direction (D1) et étant en contact et connectée électriquement à la pluralité de fiches de lignes de bits (17) disposées à intervalles le long de la première direction (D1).
